## Europäisches Patentamt

## European Patent Office

## Office européen des brevets

(11) Publication number: **0 379 293**
**A2**

# EUROPEAN PATENT APPLICATION

(21) Application number: 90300240.0

(22) Date of filing: 09.01.90

(51) Int. Cl.⁵: **H03B 9/08, H03L 7/185, H02M 3/24**

(30) Priority: 14.01.89 GB 8900816

(43) Date of publication of application:
25.07.90 Bulletin 90/30

(84) Designated Contracting States:
**DE FR IT SE**

(71) Applicant: **Ferranti International Signal plc
Bridge House Park Road Gatley
Cheadle Cheshire SK8 4HZ(GB)**

(72) Inventor: **Fisher, Frank Donald
12 Hillpark Avenue
Edinburgh EH4 7AT(GB)**
Inventor: **Ovens, Ronald
73 North Meggetland
Edinburgh EH14 1XG, Scotland(GB)**

(74) Representative: **Bradley, David Nicholas et al
Patents Department Ferranti International
plc Bridge House Park Road Gatley
Cheadle, Cheshire SK8 4HZ(GB)**

(54) **Control of power inverter.**

(57) Apparatus is provided for controlling the operation of a switch mode power inverter having a known limited frequency range in dependence upon a variable-frequency timing waveform having a greater frequency range. Measuring means (21) are provided for measuring the frequency of the timing waveform and circuit means (18) uses this to generate a synchronising pulse train having a frequency which is an integral multiple or sub-multiple of the frequency of the timing waveform and is within the operating range of the power inverter.

*Fig. 1.*

## CONTROL OF POWER INVERTER

Power inverters, particularly those used as power supplies for radar systems, are generally of the free-running type with a switching frequency of up to say 150 KHz. In normal circumstances the switching frequency is of little importance. However in some applications the switching frequency may cause noise to be introduced, particularly if the apparatus supplied with power is, itself controlled by a timing signal. In the case of radar systems using travelling-wave tubes as power amplifiers it is common to use the cathode of the tube as a voltage reference for the tube power supplies so that the modulator may be connected directly to the electrodes of the travelling-wave tube. This results in a risk of noise being added to the RF output waveform of the tube. Such noise may be minimised by filtering but this incurs a size and weight penalty, particularly in the case of heater supplies because of the high currents involved.

It is an object of the invention to provide apparatus which reduces the generation of noise by a switched mode power supply in equipment controlled by a variable-frequency timing waveform.

According to the present invention there is provided apparatus for controlling the operation of a switch mode power inverter having a known limited maximum-to-minimum operating frequency ratio in dependence upon a variable-frequency timing wave form having a greater operating frequency ratio, which includes measuring means for measuring the frequency of the timing waveform from time to time, and circuit means responsive to the output of the measuring means to generate a synchronising pulse train for application to the power inverter and having a frequency which is an integral multiple or sub-multiple of the frequency of the timing waveform and which is within the operating range of the power inverter.

The invention will now be described with reference to the accompanying drawings, in which:-

Figure 1 is a schematic diagram of a power supply for a travelling-wave tube; and

Figure 2 is a schematic block diagram of the control means of Figure 1.

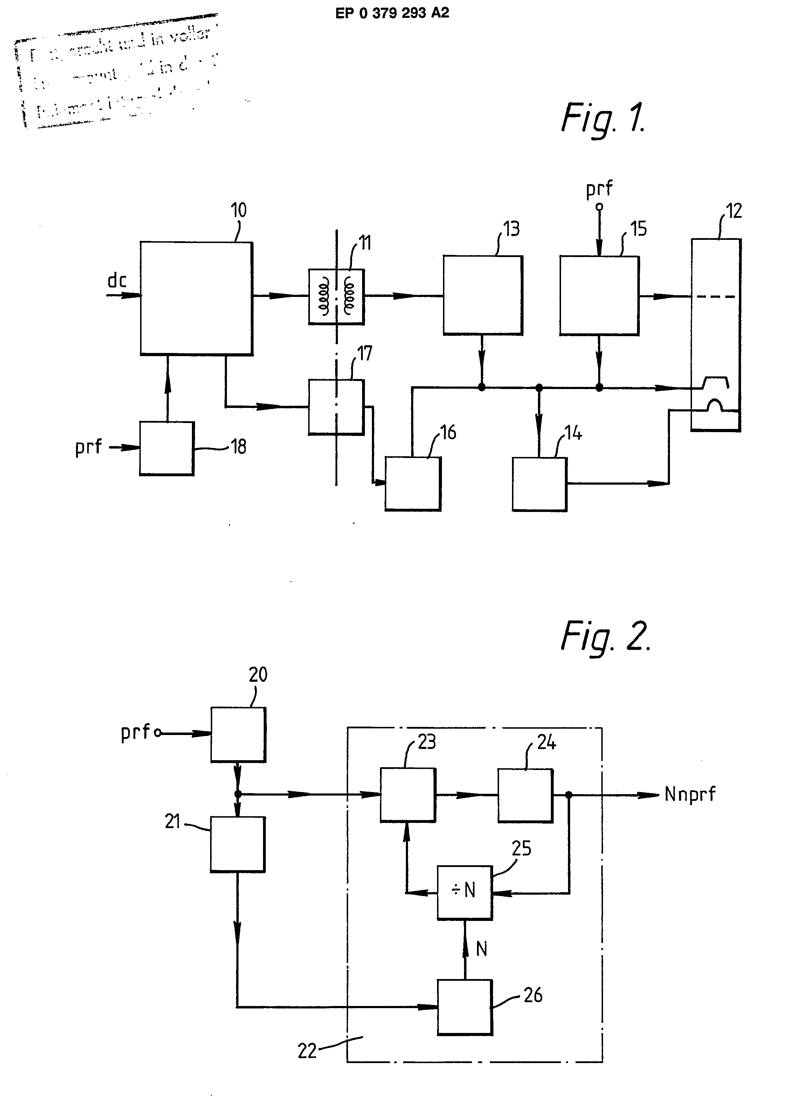

Referring now to Figure 1, this shows a switch mode power inverter 10 having a dc power supply input and applying ac output power to a transformer 11. The transformer has several secondary windings which supply power at different voltages to rectifying and smoothing units which provide power for the grid, cathode and heater of the travelling-wave tube 12. The rectifying and smoothing units are shown schematically at 13. Figure 1 also shows the heater supply regulator 14 and output switch 15, as well as a fault-monitoring unit 16 which passes signals back through an optical isolator 17 to the power inverter 10. The frequency of operation of the power inverter is controlled by the control means 18.

The frequency of operation of the switched mode power supply may be controlled over a maximum-to-minimum frequency ratio of perhaps 3 or 4:1 at most, this control being exerted by the control means 18. In the case of a radar transmitter, a common application of a travelling-wave tube, the prf of the transmitter may have to vary over a range having a maximum-to-minimum frequency ratio as large as 100:1, though the prf will always be lower than the operating frequency of the power inverter. It has been found that noise introduced by the power inverter into the output of the travelling-wave tube is at a minimum when the frequency of operator of the power inverter is an integral multiple of the prf and it is the purpose of the control means to produce this synchronisation.

The control means 18 of Figure 1 is shown in greater detail in Figure 2. The timing waveform, in this case a sample of the prf signal, is applied to a pulse shaper 20 which produces constant amplitude and constant pulse width replicas of the original prf pulses. This waveform is applied to a frequency counter 21 which measures the frequency of that timing waveform at predetermined intervals.

The shaped prf signal is also applied to circuit means 22 including a conventional phase-locked loop comprising a phase detector 23, a voltage controlled oscillator 24 and a "-n" circuit 25. The output of the phase-locked loop is a pulse train having a frequency which is a multiple of the prf. The signal applied to the divider circuit 25 is such that the output of the voltage controlled oscillator 24 is the desired multiple N of the prf. This signal is produced by a processor 26 which is supplied with a signal indicating the actual measured frequency of the prf signal and also stores details of the workable frequency range of the power inverter and of other necessary characteristics of the inverter. By way of example only, consider the situation with a power inverter which requires an applied trigger pulse to produce one half-cycle of the desired output. If the frequency range of operation is from 50KHz to 120KHz then the trigger or synchronising pulses must be provided at a frequency between 100KHz and 240KHz. Assume also that the prf of the associated radar for which the power supply is used is in the range from 30KHz to 120KHz. The processor 26 must therefore operate to ensure that the multiplier N lies in the range of the inverter.

In the simple case outlined above the output of the frequency counter 21 indicates the actual prf of the radar at the time of measurement. The processor 26 will use this value such that if it lies in the range 30KHz to 60KHz a multiplier of N = 4 is produced, so that the inverter is supplied with synchronising pulses at a prf between 120KHz and 240KHz. Equally, if the radar prf lies in the range 60KHz to 120KHz then the multiplier is N = 2, so that the synchronising pulses are at a prf between 120KHz and 240KHz as before, within the operating range of the inverter.

If the prf range of the radar was greater then more than two values of N would be necessary.

The output N from the processor may conveniently be a digital signal applied to the divider circuit 25.

The use of an inverter to supply a travelling-wave tube is only one example of the manner in which the invention may be used. The pulse rate of the timing waveform with which the inverter is to be synchronised may be greater than the inverter operating frequency, in which case the ratio N will have to be an integral sub-multiple of the pulse rate of the timing waveform.

The rate at which the frequency counter 21 measures the frequency of the timing waveform will depend upon the nature of the source of the timing wave form. Clearly if the timing waveform changes its prf frequently, as for example in the case of a frequency-agile radar, then frequent checks on the prf will be necessary.

As a consequence of applying the invention to a switched mode power inverter the wound components of the inverter need be no larger than those used in a fixed frequency power inverter.

## Claims

1. Apparatus for controlling the operation of a switch mode power inverter having a known limited maximum-to-minimum operating frequency ratio in dependence upon a variable-frequency timing waveform having a greater operating frequency ratio, which includes measuring means for measuring the frequency of the timing waveform from time to time, and circuit means responsive to the output of the measuring means to generate a synchronising pulse train for application to the power inverter and having a frequency which is an integral multiple or sub-multiple of the frequency of the timing waveform and which lies withinm the operating range of the power inverter.

2. Apparatus as claimed in Claim 1 in which the circuit means includes a phase-locked loop and processor means for determining the said integral multiple or sub-multiple factor.

3. Apparatus as claimed in Claim 2 in which the phase-locked loop includes a voltage-controlled oscillator the output of which forms the synchronsing pulse train.

*Fig. 1.*

*Fig. 2.*